# EUROPEAN PATENT APPLICATION

(11) **EP 1 677 320 A1**
(43) Date of publication of application: **05.07.2006**
(21) Application number: 05025289.9
(22) Date of filing: 18.11.2005
(51) Int. Cl.: H01G 4/12, H05K 1/16

(54) **Oxygen doped firing of barium titanate on copper foil**

(30) Priority: 28.12.2004 US 23815
(71) Applicant: E.I. du Pont de Nemours and Company, Wilmington, DE 19898 (US)
(72) Inventor: Borland, William J., Cary North Carolina 27513 (US)
(74) Representative: Towler, Philip Dean

(57) **Abstract**

The present invention relates to a method of making an embedded capacitor and a printed wiring board and includes providing a metallic foil (110); forming a first dielectric layer (128) over the metallic foil; forming a conductive layer (132) over at least a portion of the first dielectric layer; controlling an oxygen content of a controlled atmosphere; and firing the first dielectric layer and the conductive layer in a firing zone in the controlled atmosphere.

## Description

### BACKGROUND

The technical field is, in general, capacitors. More particularly, the technical field includes capacitors embedded in printed circuit boards and even more particularly embedded capacitors made from thick film capacitors formed on copper foil.

The practice of embedding capacitors in printed circuit boards (PCB) or printed wiring boards (PWB) allows for reduced circuit size and improved circuit performance. Capacitors are typically embedded in panels that are stacked and connected by interconnection circuitry, wherein the stack of panels forms a printed circuit board. The stacked panels are generally referred to as "innerlayer panels."

Capacitors and other passive circuit components can be embedded in printed circuit boards formed by fired-on-foil technology. One or more "separately fired-on-foil" capacitors are formed by depositing a thick-film capacitor material layer onto a metallic foil substrate, depositing a top electrode material over the thick-film capacitor material layer, and firing under thick-film firing conditions. Firing is followed by lamination and etching steps. The resulting article may be laminated with other layers to form a multilayer printed wiring board containing embedded capacitors.

Embedded capacitors are subject to requirements such as acceptable breakdown voltage, stability of capacitance within specified temperature ranges, low dielectric loss, high insulation resistance, and amenability to printed circuit board manufacturing techniques.

Thick-film firing conditions generally relate to the conditions existing in the furnace during the firing of the thick-film capacitors. Such conditions include firing peak temperature, time at the peak temperature, the heating and cooling rates, and the type of atmosphere contained in the furnace. Typical copper thick-film firing conditions include a peak temperature of approximately 900°C, a time at peak temperature of approximately 10 minutes, and a heating and cooling rate of approximately 50°C per minute. An atmosphere composed of nitrogen continuously flowing into the furnace is designed to protect the copper from oxidation. The flow of nitrogen into the furnace continuously exposes the parts being fired to fresh nitrogen as they pass through the furnace. This is accomplished by supplying nitrogen into various parts of the furnace so that nitrogen gas flow is opposite to that of the furnace belt direction. The nitrogen is generally supplied from a liquid nitrogen source and typically has an oxygen content of less than 1 part per million (ppm).

The thick-film capacitor material may include high dielectric constant (K) functional phases, glasses and/or dopants, and should have a high dielectric constant after firing. High dielectric constant functional phases may be defined as materials with dielectric constants above 1000. Such materials include perovskites of the general formula ABO₃, such as crystalline barium titanate (BT), lead zirconate titanate (PZT), lead lanthanum zirconate titanate (PLZT), lead magnesium niobate (PMN), and barium strontium titanate (BST).

These materials, however, have varying degrees of stability with respect to the furnace atmospheric conditions. If the atmosphere within the furnace becomes too reducing at the high temperatures, they may suffer from some form of reduction. For example, barium titanate may experience loss of oxygen from the crystal lattice leading to oxygen vacancies resulting in low insulation resistance in the capacitor.

What is needed, then, is a process that significantly reduces the reduction potential in the dielectric without oxidizing the copper foil.

### SUMMARY

According to one embodiment, a method of making a capacitor with high insulation resistance comprises providing a metallic foil; forming a dielectric over the metallic foil; forming a first electrode over a portion of the dielectric; and firing the components in a nitrogen atmosphere that is doped with oxygen.

Capacitors made according to the above process have relatively high insulation resistance and can be embedded into innerlayer panels which, in turn, can be incorporated into printed wiring boards. The resulting capacitors have high insulation resistance along with other desirable properties.

Those skilled in the art will appreciate the above stated advantages and other benefits of various additional embodiments and aspects of this disclosure upon reading the following detailed description.

### BRIEF DESCRIPTION OF THE DRAWINGS

The detailed description will refer to the following drawings wherein:
FIGS. 1A-1D provide a series of elevation views illustrating a method of manufacturing a single-layer capacitor on metallic foil design.
FIG. 2 is a phase stability diagram for metals and their oxides at various temperatures and partial pressures of oxygen; and
FIG. 3 is a calculated plot of equilibrium oxygen vacancy defect concentration (Vo) expected as a function of partial pressure of oxygen for pure barium titanate fired at 900°C.

According to common practice, the various features of the drawings are not necessarily drawn to scale. Dimensions of various features may be expanded or reduced to more clearly illustrate the various disclosed embodiments.

### DETAILED DESCRIPTION

Methods of improving insulation resistance of thick-film capacitors on copper foil are disclosed.

Capacitors manufactured according to the teachings of this disclosure may have insulation resistances greater than 1 GΩ along with other desirable properties such as relatively high dielectric constants and relatively low dissipation factors.

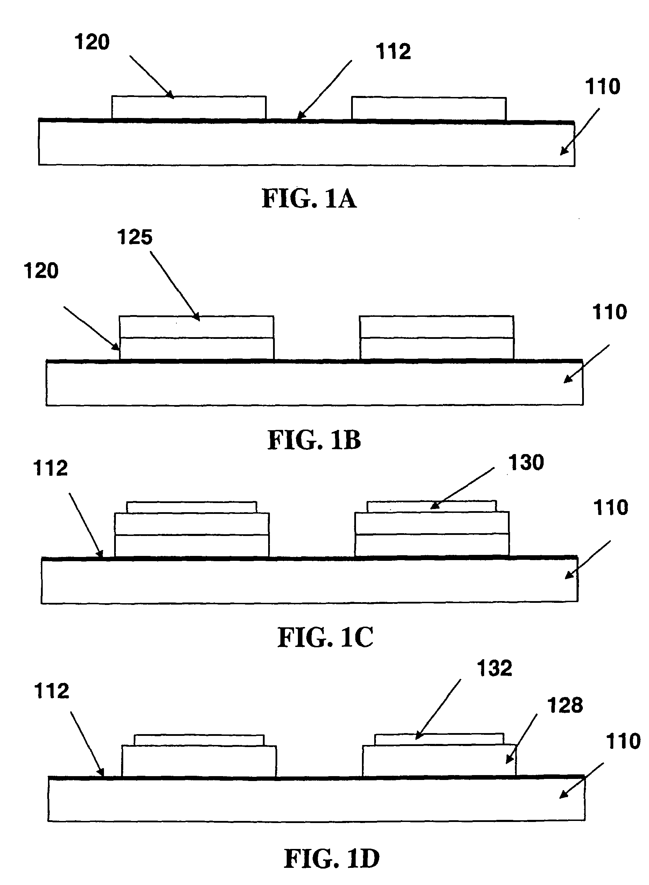

FIGS. 1A-1 D illustrate a method of manufacturing a single-layer capacitor on metallic foil design. For illustrative purposes, only two capacitors are visible in the sectional views. However, one, two, three, or more capacitors can be formed on a foil by the methods described in this disclosure. The following written description is addressed to the formation of only one of the illustrated capacitors for the sake of simplicity.

In FIG. 1A, metallic foil 110 is provided. Metallic foil 110 may be of a type generally available in the industry, for example, copper, copper-invar-copper, invar, nickel, nickel-coated copper, or other metals and alloys having melting points that exceed the firing temperature for thick film pastes. Suitable foils include foils comprised predominantly of copper, such as reverse treated copper foils, double-treated copper foils, and other copper foils commonly used in the multilayer printed circuit board industry. The thickness of metallic foil 110 may be in the range of, for example, about 1-100 µm. Other thickness ranges include 3-75 µm, and more specifically 12-36 µm. These thickness ranges correspond to between about 1/3 oz. and 1 oz. copper foil.

Foil 110 may be pretreated by applying underprint 112 to foil 110. Underprint 112 is shown as a surface coating in FIG. 1A, and may be a relatively thin layer applied to the component-side surface of the foil 110. Underprint 112 is selected to adhere well to metal foil 110 and to layers subsequently deposited over underprint 112. Underprint 112 may be formed, for example, from a paste applied to foil 110 that is fired at a temperature below the melting point of foil 110. The underprint paste may be printed as an open coating over the entire surface of foil 110, or printed over selected areas of foil 110. It is generally more economical to print the underprint paste over selected areas of foil 110 rather than over the entire foil 110. However, it may be desirable to coat the entire surface of foil 110 if oxygen-doped firing is used in conjunction with copper foil 110, because glass content in the underprint retards oxidative corrosion of copper foil 110.

One exemplary paste suitable for use as underprint 112 has the following composition (amounts relative by mass):

| | |
|---|---|
| Copper powder | 58.4 |
| Glass A | 1.7 |
| Cuprous oxide powder | 5.8 |
| Vehicle | 11.7 |
| TEXANOL® solvent | 12.9 |
| Surfactant | 0.5 |
| Total | 91.0 |

In this composition,
- Glass A comprises:: lead germanate of the composition Pb₅Ge₃O₁₁
- Vehicle comprises:: Ethyl cellulose N200 11 %
- TEXANOL®: 89%
- Surfactant comprises:: VARIQUAT® CC-9 NS surfactant
TEXANOL® is available from Eastman Chemical Co. VARIQUAT® CC-9 NS is available from Ashland Inc.

A dielectric material is deposited over underprint 112 on foil 110, forming first dielectric material layer 120 (FIG. 1A). The capacitor dielectric material may be, for example, a thick-film capacitor paste that is screen-printed onto foil 110. First dielectric material layer 120 is then dried. In FIG. 1 B, second dielectric material layer 125 is then applied, and dried. In an alternative embodiment, a single layer of capacitor dielectric material may be deposited to an equivalent thickness of the two layers 120, 125 in a single screen printing step. One suitable thick-film capacitor material disclosed for use in fired-on-foil embodiments has the following composition (amounts relative by mass):

| | |
|---|---|
| Barium titanate powder | 68.55 |
| Lithium fluoride | 1.0 |
| Barium fluoride | 1.36 |
| Zinc fluoride | 0.74 |
| Glass A | 10.25 |
| Glass B | 1.0 |
| Glass C | 1.0 |
| Vehicle | 5.9 |
| TEXANOL® solvent | 8.7 |
| Oxidizer | 1.0 |
| Phosphate wetting agent | 0.5 |
| Total | 100.00 |

In this composition,
- Glass A comprises:: lead germanate of the composition Pb₅Ge₃O₁₁
- Glass B comprises:: Pb₄BaGe_{1.5} Si_{1.5} O₁₁
- Glass C comprises:: Pb₅GeSiTiO₁₁
- Vehicle comprises:: Ethyl cellulose N200 11 %
- TEXANOL® solvent: 89%
- Oxidizer comprises:: Barium nitrate powder 84%
- Vehicle: 16%

In FIG. 1C, conductive material layer 130 is formed over second dielectric material layer 125, and dried. Conductive material layer 130 can be formed by, for example, screen-printing a thick-film metallic paste over second dielectric material layer 125. The paste used to form underprint 112 is also suitable for forming conductive material layer 130. In general, for this embodiment, the surface area of first and second dielectric layers 120, 125, as would be seen in a top plan view (not shown), is larger than the area of conductive material layer 130.

First dielectric material layer 120, second dielectric material layer 125, and conductive material layer 130 are then co-fired to sinter the resulting structure together.

The post-fired structure section is shown in front elevation in FIG. 1 D. Firing results in a single dielectric 128 formed from dielectric layers 120 and 125, because the boundary between dielectric layers 120 and 125 is effectively removed during co-firing. Top electrode 132 also results from the co-firing step.

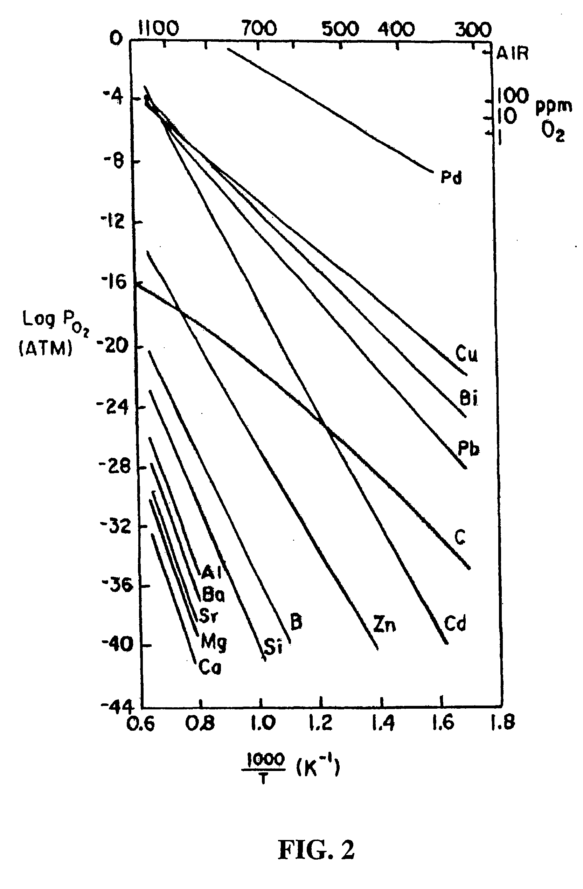

FIG. 2 is a phase stability diagram for various oxides at various temperatures and partial pressures of oxygen (PO₂) taken from "Electronic Ceramics", R. Buchanan, Ed., Chap. 8, Marcel Dekker, New York, 1990. From diagram one may determine the appropriate atmosphere that will allow any oxide or metal to remain stable for a given temperature. For example, the diagram predicts that at 900°C, copper is in equilibrium with its oxide at a partial pressure of oxygen of 10⁻⁸ atm. Many thick-film compositions contain copper oxide. To maintain copper oxide as copper oxide, therefore, an atmosphere greater than a partial pressure of oxygen of 10⁻⁸ atm may be chosen. A partial pressure of oxygen of approximately 10⁻⁶ atm (- 1 ppm of oxygen) is generally chosen, as it represents the typical purity of liquid nitrogen. This level of oxygen at 900°C would be at first sight oxidizing to copper and would appear to be deleterious. However, the rate of oxidation of copper at these atmospheres is very slow, such that that copper fired at 900°C in an atmosphere of a few parts per million of oxygen is still essentially free of oxidation. In addition, copper can tolerate much higher levels of oxygen at lower temperatures without serious oxidation.

FIG. 2 also illustrates stability thermodynamics for carbon. Carbon is a component of the capacitor material vehicle system, and is removed during the initial phases of firing in the burnout zones of the furnace. If carbon is not completely removed in the burnout zones, it will create a highly reducing local atmosphere at 900°C that has a partial pressure of oxygen of approximately 10⁻¹⁸ atm. When in direct contact with the carbon or within its local atmosphere at this temperature, barium titanate would be partially reduced and oxides such as copper oxide and lead oxide would be rapidly reduced to metal. Such reactions would result in very low insulation resistance or shorting of the dielectric. It is therefore important that the total level of oxygen in the nitrogen flow into the burnout zones is sufficient to completely oxidize and remove the organic components of the vehicle system. This amount can be calculated from the amount of paste deposited on the substrate and the throughput of parts through the furnace.

For example, for a total of 3 grams of wet paste deposited on the substrate and containing about 1% by weight of ethyl cellulose, a nitrogen flow of 1100 cubic feet per hour into the burn out zones, with approximately 20 ppm of oxygen, would be sufficient.

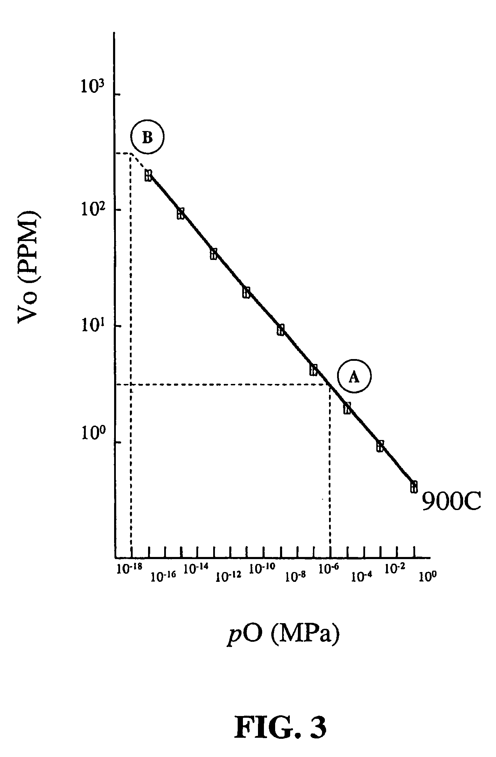

FIG. 3 is a calculated plot of equilibrium oxygen vacancy defect concentrations (Vo) expected in pure barium titanate fired at 900°C as a function of oxygen partial pressure. The plot was derived from empirical activation energy of oxygen vacancy concentration data disclosed in "Defect Chemistry of Metal Oxide", D.M. Smyth, Chap. 14, Oxford University Press, 2000. According to FIG. 3, firing barium titanate at 900°C in a partial pressure of oxygen of 10⁻⁶ atm should result in a defect density of approximately 8-10 ppm (see point "A" in FIG. 3). Such a defect density would result in a slightly reduced but acceptable insulation resistance.

However, if the organic component of the vehicle system is not completely removed, as previously described, a local partial pressure of oxygen of approximately 10⁻¹⁸ atm will result at 900°C. In such a case, barium titanate in the vicinity of that atmosphere will generate a defect density of approximately 600 ppm (see point "B" in FIG. 3), resulting in a much lower and undesirable insulation resistance. Removing the carbon during the burnout process is necessary to producing a fired barium titanate with good insulation resistance.

Therefore, an optimum process for firing capacitors made with barium titanate-based dielectrics on copper foil includes utilizing oxygen-doped burnout zones to effectively oxidize and completely remove the organic content of the vehicle system, without seriously oxidizing the copper foil. The actual oxygen dopant level required in the burnout zones depends on the weight of the paste deposit, the throughput, and the nitrogen flow into the burnout zone. Calculations can be performed to determine the theoretical amount of oxygen required.

To ascertain the oxygen level practically, the oxygen dopant level may be adjusted in the burnout zones so that the oxygen level never falls below 1 ppm in any of the burnout zones when parts are passing through the furnace in a fully loaded situation. This ensures that essentially all organic material from the vehicle system will be removed during this time frame. The firing zone is adjusted to have a low oxygen content to maintain low oxidation of the copper without serious reduction of the barium titanate. The cooling zone may also have increased oxygen levels so that relatively oxidizing conditions for the barium titanate exist on cooling, but the temperature is sufficiently low that the copper foil does not become seriously oxidized.

### EXAMPLES 1-11

| Table 1 | | | | | |
|---|---|---|---|---|---|
| Insulation Resistance for Undoped and Doped Firing (One fire 930C; Average of 48 capacitors; IR tested at 100V for 15 seconds) | | | | | |
| Example | Oxygen Dopant Level (ppm O₂) | | | IR (megaoh m) | Copper Foil Condition |
| | Burnout Zone | Firing Zone | Cooling Zone | | |
| 1 | 0 | 0 | 0 | 22 | Shiny |
| 2 | 0 | 0 | 0 | 557 | Shiny |
| 3 | 24 | 3 | 3 | 1050 | Shiny |
| 4 | 39 | 3 | 3 | 1987 | Shiny |
| 5 | 24 | 3 | 12 | 3875 | Shiny |
| 6 | 24 | 3 | 10 | 2589 | Shiny |
| 7 | 20 | 3 | 10 | 4192 | Shiny |
| 8 | 24 | 6 | 6 | 3435 | Oxidized |
| 9 | 39 | 6 | 6 | 264 | Very Oxidized |
| 10 | 24 | 12 | 12 | 2118 | Oxidized |
| 11 | 39 | 12 | 12 | 105 | Very Oxidized |

In TABLE 1, examples 1 through 11 show that optimum firing zone oxygen levels are approximately 3 ppm. In all cases where 3 ppm was used in the firing zone, insulation resistance was above 1 GO. Optimum burnout zone oxygen is approximately 20 ppm and above for this example. It appears that this range can be quite large and can be extended to at least 40 ppm. The optimum amount depends on the amount of paste deposit on the foil and the throughput through the furnace and may be greater than 40 ppm for high deposits and throughputs. The cooling zone is similar in that a reasonably wide range of 3 ppm to 18 ppm has very good insulation resistance and low oxidation of the copper when combined with low oxygen in the firing zone, and 20-39 ppm of oxygen in the burnout zone.

In the above embodiments, the thick-film pastes may comprise finely divided particles of ceramic, glass, metal or other solids. The particles may have a size on the order of 1 *µ*m or less, and may be dispersed in an "organic vehicle" comprising polymers dissolved in a mixture of dispersing agent and organic solvent. Typically, the thick-film glass component of a capacitor material is inert with respect to the high K functional phase, and essentially acts to cohesively bond the composite together and to bond the capacitor composite to the substrate. Preferably, only small amounts of glass are used so that the dielectric constant of the high K functional phase is not excessively diluted. Use of a glass with a relatively high dielectric constant is preferred because the dilution effect is less significant, and a high dielectric constant of the composite can be maintained. Lead germanate glass of the composition Pb₅Ge₃O₁₁ is a ferroelectric glass that has a dielectric constant of approximately 150, and is therefore suitable. Modified versions of lead germanate are also suitable. For example, lead may be partially substituted by barium, and the germanium may be partially substituted by silicon, zirconium, and/or titanium.

During firing, the glass component of the capacitor material softens and flows before the peak firing temperature is reached, coalesces, and encapsulates the functional phase forming the fired capacitor composite.

Pastes used to form the electrode layers may be based on metallic powders of copper, nickel, silver, silver-palladium compositions, or mixtures of these compounds. Copper powder compositions may be preferred in some applications.

The desired sintering temperature is determined by the metallic substrate melting temperature, the electrode melting temperature, and the chemical and physical characteristics of the dielectric composition. For example, one set of sintering conditions suitable for use in the above embodiments is a nitrogen firing process having a 10 minute residence time above 900°C, and a 6 minute residence time at a peak temperature of 930°C.

The foregoing disclosure illustrates and describes various embodiments. Additionally, it is to be understood that the teachings of this disclosure are capable of use in various other combinations, modifications, and environments, and are capable of changes or modifications within the scope of the inventive concept as expressed herein, commensurate with the above teachings, and/or within the skill or knowledge of the relevant art.

The embodiments described herein above are further intended to explain best modes known of practicing the invention and to enable others skilled in the art to utilize the invention in such disclosed embodiments, or other embodiments, and with the various modifications required by the particular applications or uses contemplated, and recognized by a person with skill in the art. Accordingly, the description is not intended to limit the application of the teachings to the particular form disclosed herein. Also, it is intended that the appended claims be construed to include alternative embodiments, not explicitly defined in the detailed description.

## Claims

1. A method of making a capacitor, the method comprising:
providing a metallic foil; forming a first dielectric layer over the metallic foil; forming a conductive layer over at least a portion of the first dielectric layer; controlling a oxygen content of a controlled atmosphere; and firing the first dielectric layer and the conductive layer in a firing zone in the controlled atmosphere.

2. The method of claim 1, wherein said controlling an oxygen content of a controlled atmosphere comprises: establishing a first oxygen level in the firing zone;
providing a burnout zone having a second oxygen level which is higher than the first oxygen level; and removing any organic material present in the capacitor by effecting a burnout operation.

3. The method of claim 2, wherein the first oxygen level in the firing zone is approximately 3 ppm.

4. The method of claim 2, wherein the second oxygen level in the burnout zone is at least 20 ppm.

5. The method of claim 4, wherein the second oxygen level in the burnout zone is less than 40 ppm.

6. The method of claim 2, further comprising providing a cooling zone after the firing zone, wherein an oxygen level in the cooling zone is in the range of 3-18 ppm.

7. The method of claim 2, further comprising providing a cooling zone after the firing zone, wherein:
the first oxygen level in the firing zone is approximately 3 ppm,
the second oxygen level in the burnout zone is in a range of approximately 20-40 ppm, and
an oxygen level in the cooling zone is in the range of approximately 3-18 ppm.

8. The method of claim 1, further comprising forming a second dielectric layer over the first dielectric layer, wherein the conductive layer is formed over the second dielectric layer and the at least a portion of the first dielectric layer.

9. The method of claim 8, further comprising forming the first dielectric layer and the second dielectric layer together into a single dielectric layer.

10. The method of claim 1, further comprising forming an underprint layer on the metallic foil before said forming a first dielectric layer and said forming a conductive layer, wherein the underprint layer adheres to the metallic foil and the first dielectric layer.

11. The method of claim 10, wherein the underprint layer comprises a glass.

12. The method of claim 10, wherein the underprint layer comprises lead germanate.

13. The method of claim 10, wherein the underprint layer comprises copper.

14. The method of claim 10, wherein the underprint layer comprises a metallic powder.

15. The method of claim 10, further comprising firing the underprint layer at a temperature that is less than a melting point of the metallic foil.

16. The method of claim 1, wherein said providing a metallic foil comprises providing a foil selected from the group consisting of copper, copper-invar-copper, invar, nickel, and nickel-coated copper.

17. The method of claim 1, wherein said first dielectric layer comprises barium.

18. The method of claim 1, wherein said forming a conductive layer includes providing a paste comprising a metallic powder, wherein said metallic powder comprises a metal selected from the group consisting of copper, nickel, silver, and silver-palladium.

19. An embedded capacitor produced by the method of claim 1.

20. A printed wiring board comprising the embedded capacitor of claim 19.
